# EUROPEAN PATENT SPECIFICATION

(11) **EP 3 647 341 B1**
(45) Date of publication and mention of the grant of the patent: **07.08.2024**
(21) Application number: 19205274.4
(22) Date of filing: 25.10.2019
(51) Int. Cl.: C08G 77/04, C08G 77/20, C08G 77/24, C08G 77/38, C08K 5/05, C08K 5/10, C08K 5/103, G03F 7/027, G03F 7/075

(54) **(METH)ACRYLOYL GROUP-CONTAINING ORGANOSILOXANE**
(METH)ACRYLOYLGRUPPENHALTIGES ORGANOSILOXAN
ORGANOSILOXANE CONTENANT UN GROUPE (MÉTH)ACRYLOYLE

(30) Priority: 29.10.2018 JP 2018202925
(43) Date of publication of application: 06.05.2020
(73) Proprietor: Shin-Etsu Chemical Co., Ltd., Tokyo 100-0004 (JP)
(72) Inventor: Iguchi, Hiroyuki, Annaka-shi, Gunma 379-0224 (JP)
(74) Representative: V.O.

(56) References cited:
- EP-A1- 2 720 085
- US-A- 6 069 186
- E R CHUNG ET AL: "Photopolymerization and curing shrinkage of silicon-containing multifunctional methacrylates", 31 December 2002 (2002-12-31), XP055668262, Retrieved from the Internet <URL:https://link.springer.com/content/pdf/10.1023/A:1016554415768.pdf> [retrieved on 20200213]
- EFROSYNI THEMISTOU ET AL: "Synthesis and Characterization of Star Polymers and Cross-Linked Star Polymer Model Networks Containing a Novel, Silicon-Based, Hydrolyzable Cross-Linker", MACROMOLECULES, AMERICAN CHEMICAL SOCIETY, WASHINGTON, DC, UNITED STATES, vol. 37, no. 18, 1 January 2004 (2004-01-01), pages 6734 - 6743, XP002533454, ISSN: 0024-9297, [retrieved on 20040806], DOI: 10.1021/MA049618+

## Description

### FIELD OF THE INVENTION

The present invention relates to an organosiloxane having at least four and up to six (meth)acryloyl groups and a method for preparing the same.

Various (meth)acryloyl group-containing organosiloxanes are known as an additive for UV-curable materials or a crosslinking agent for addition-curable or UV-curable silicone rubbers. For example, JP application Laid-Open No. 2010-248446, Patent Literature 1, describes a silicone resin composition for encapsulating optical semiconductors, which composition is excellent in curing and has an excellent adhesion property, and also describes a (meth)acryloyl group-containing organopolysiloxane which has at least two (meth)acryloyl groups and at least one alkoxysilyl group and has a weight average molecular weight of from 10,000 to 150,000.

JP application Laid-Open No. 2015-101562, Patent Literature 2, describes a (meth)acryloyl group-containing organohydrogensiloxane which has both a hydrosilyl group and a (meth)acryloyl group in a molecule, so as to simultaneously cause heat curing and UV curing and, therefore, to be useful as a crosslinking agent.

WO2018/003381, Patent Literature 3, describes a UV-curable silicone composition comprising a specific UV-curable organopolysiloxane component, a monofunctional ethylene group-containing compound having no siloxane structure and/or a polyfunctional, ethylene group-containing compound having no siloxane structure.

EP 2720085 A1, Patent Literature 4, discloses a photocurable composition and an organic light emitting display apparatus including a barrier formed of the photocurable composition. The photocurable composition includes (A) a photocurable monomer; (B) a silicon-containing monomer; and (C) a photopolymerization initiator, wherein the (B) silicon-containing monomer has the structure of Formula 1 detailed in paragraphs [20] to [22] of EP 2720085 A1.

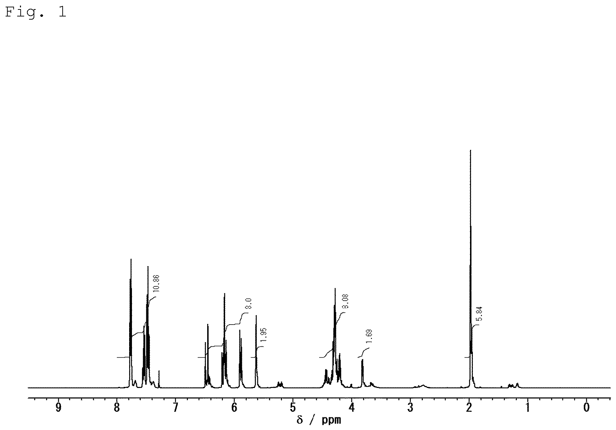

C.M. Chung et al., Journal of Materials Science Letters, (2002) 21:1093-1095, Non-patent Literature 1, discloses a process for preparing organic-inorganic hybrid materials involving the step of photopolymerizing a silicon-containing multifunctional methacrylate monomer, the structures of which are shown therein in Figure 1.

E. Themistou et al., Macromolecules (2004) 37:6734-6743, Non-patent Literature 2, discloses the use of silicon-based dimethacrylate compounds as crosslinker in a process for preparing crosslinked star polymer networks.

U.S. Patent No. 6,069,186, Patent Literature 5, describes a radiation-curable silicon rubber composition which includes (A) an organopolysiloxane as represented in formula (1) therein having radiation-sensitive (meth)acryoyl groups at both terminals of the molecular chain; (B) a photosensitizer; (C) a tetra-alkoxysilane or a partial hydrolysis condensation product thereof; and (D) optionally, an organic titanium compound.

### PRIOR LITERATURE

Patent Literature 1: JP application Laid-Open No. 2010-248446.
Patent Literature 2: JP application Laid-Open No. 2015-101562.
Patent Literature 3: WO2018/003381.
Patent Literature 4: EP 2720085 A1.
Patent Literature 5: U.S. Patent No. 6,069,186.
Non-patent Literature 1: C.M. Chung et al., "Photopolymerization and curing shrinkage of silicon-containing multifunctional methacrylates", Journal of Materials Science Letters, (2002) 21:1093-1095.
Non-patent Literature 2: E. Themistou et al., "Synthesis and Characterization of Star Polymers and Cross-Linked Star Polymer Model Networks containing a Novel, Silicon-based, Hydrolyzable Cross-Linker", Macromolecules (2004) 37:6734-6743.

### SUMMARY OF THE INVENTION

One of the purposes of the present invention is to provide a (meth)acryloyl group-containing organosiloxane which provides a strong cured product showing excellent adhesion to a substrate.

The present inventors have conducted research on an organosiloxane having at least four (meth)acryloyl groups in a molecule, and have invented a (meth)acryloyl group-containing organosiloxane represented by formula (1) as described below.

Thus, the present invention provides a (meth)acryloyl group-containing organosiloxane represented by the following formula (1): 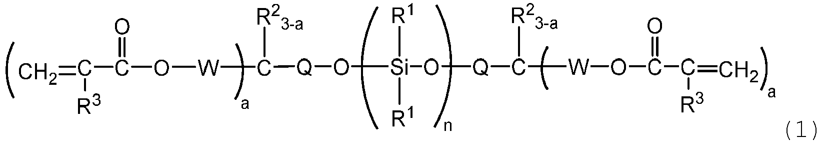
wherein R¹ is, independently of each other, an aliphatic hydrocarbon group having 1 to 10 carbon atoms or an aromatic hydrocarbon group having 6 to 12 carbon atoms,
R² is, independently of each other, a hydrogen atom, an alkoxy group having 1 to 6 carbon atoms, an aryloxy or aralkyloxy group having 6 to 12 carbon atoms, an aliphatic hydrocarbon group having 1 to 6 carbon atoms, or an aromatic hydrocarbon group having 6 to 12 carbon atoms,
R³ is, independently of each other, a hydrogen atom or a methyl group,
Q is a single bond or an alkylene group having 1 to 6 carbon atoms,
W is a divalent hydrocarbon group which has 1 to 6 carbon atoms and may have an ether bond,
a is 2 or 3, and
n is an integer of from 1 to 6;
and a method for preparing the same as defined in appended claim 4.

### EFFECTS OF THE INVENTION

The (meth)acryloyl group-containing organosiloxane of the present invention has at least four and up to six (meth)acryloyl groups in a molecule and, therefore, provides a very strong cured product. Further, a moiety having a (meth)acryloyl-containing group and a moiety of organosiloxane are connected with each other via a -C-O-Si-structure and, thereby, the cured product has excellent adhesion to a substrate.

### BRIEF EXPLANATION OF THE DRAWING

Figure 1 is a ¹H-NMR spectrum of the compound prepared in Example 1.

### DETAILED DESCRIPTION OF THE INVENTION

The present invention will be described in more detail.

The (meth)acryloyl-modified organosiloxane of the present invention is represented by the following formula (1) : 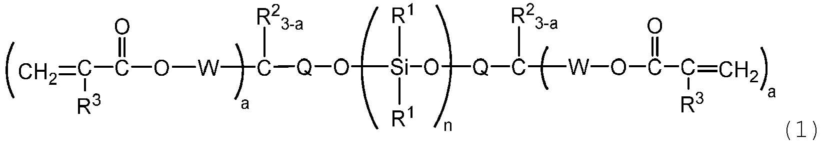
wherein R¹ is, independently of each other, an aliphatic hydrocarbon group having 1 to 10 carbon atoms or an aromatic hydrocarbon group having 6 to 12 carbon atoms,
R² is, independently of each other, a hydrogen atom, an alkoxy group having 1 to 6 carbon atoms, an aryloxy or aralkyloxy group having 6 to 12 carbon atoms, an aliphatic hydrocarbon group having 1 to 6 carbon atoms, or an aromatic hydrocarbon group having 6 to 12 carbon atoms,
R³ is, independently of each other, a hydrogen atom or a methyl group,
Q is a single bond or an alkylene group having 1 to 6 carbon atoms,
W is a divalent hydrocarbon group which has 1 to 6 carbon atoms and may have an ether bond,
a is 2 or 3, and
n is an integer of from 1 to 6.

R¹ is, independently of each other, an aliphatic hydrocarbon group having 1 to 10 carbon atoms or an aromatic hydrocarbon group having 6 to 12 carbon atoms, preferably an aliphatic hydrocarbon group having 1 to 6 carbon atoms or an aromatic hydrocarbon group having 6 to 10 carbon atoms, more preferably an aliphatic hydrocarbon group having 1 to 3 carbon atoms or an aromatic hydrocarbon group having 6 to 8 carbon atoms. Examples of the aliphatic hydrocarbon group include alkyl groups such as a methyl, ethyl, propyl or butyl group and cycloalkyl groups such as a cyclopentyl or cyclohexyl group. Among these, a methyl group and a cyclohexyl group are preferred, and a methyl group is particularly preferred. Examples of the aromatic hydrocarbon group include aryl groups such as a phenyl, tolyl, naphthyl or biphenyl group and aralkyl groups such as a benzyl, phenylethyl or phenylpropyl group. Among these, a phenyl group is preferred.

R² is, independently of each other, a hydrogen atom, an alkoxy group having 1 to 6 carbon atoms, an aryloxy or aralkyloxy group having 6 to 12 carbon atoms, an aliphatic hydrocarbon group having 1 to 6 carbon atoms, or an aromatic hydrocarbon group having 6 to 12 carbon atoms. Examples of the aliphatic hydrocarbon group and the aromatic hydrocarbon group include those given as examples for R¹. Examples of the alkoxy group include alkyloxy groups such as a methoxy, ethoxy, propoxy or butoxy group and cycloalkyloxy groups such as a cyclopentyloxy or cyclohexyloxy group. Among these, a methoxy group and an ethoxy group are preferred, and a methoxy group is particularly preferred. Examples of the aryloxy group include a phenoxy, tolyloxy, naphthoxy or biphenyloxy group. Examples of the aralkyloxy group include a benzyloxy, phenylethoxy or phenylpropoxy group. Among these, a phenoxy group is preferred. R² is preferably a hydrogen atom, an alkoxy group having 1 to 3 carbon atoms, an aryloxy group having 6 to 10 carbon atoms, an alkyl group having 1 to 3 carbon atoms, or an aryl group having 6 to 10 carbon atoms, more preferably a hydrogen atom, an alkoxy group having 1 or 2 carbon atoms, an aryloxy group having 6 to 8 carbon atoms, an alkyl group having 1 or 2 carbon atoms, or an aryl group having 6 to 8 carbon atoms.

Q is a single bond or an alkylene group having 1 to 6, preferably 1 to 4 carbon atoms and preferably a single bond or methylene. n is an integer of from 1 to 6, preferably an integer from 1 to 4, more preferably 1 or 2; and a is an integer of from 1 to 3, preferably 2 or 3. W is a divalent hydrocarbon group which has 1 to 6, preferably 1 to 3 carbon atoms and may have an ether bond. Examples of W include alkylene groups such as a methylene group and an ethylene group and oxyalkylene groups such as an oxyethylene group. Preferred is an alkylene group having 1 to 6, more preferably 1 to 3 carbon atoms, and particularly a methylene group.

Examples of the (meth)acryloyl group-containing organosiloxane represented by the formula (1) include compounds represented by the following formulae (with the exception of the compound having the structure on the left in the second line of listed compounds):

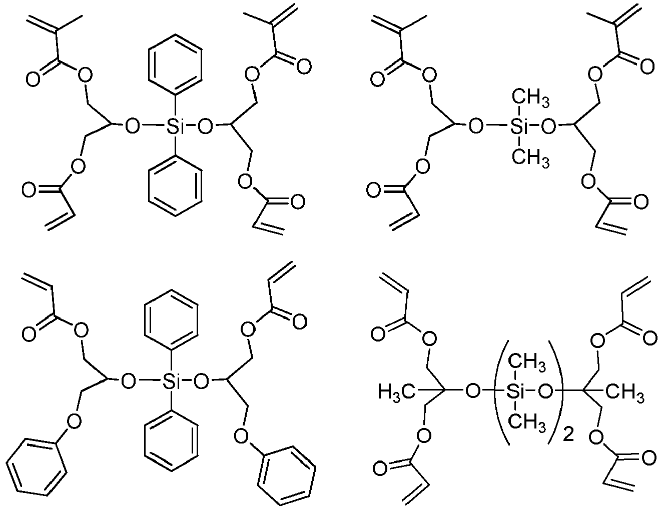

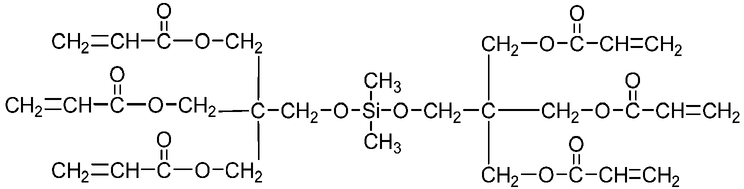

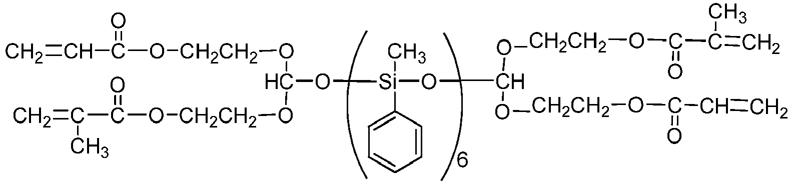

### [Method for preparing the (meth)acryloyl group-containing organosiloxane]

A method for preparing the (meth)acryloyl group-containing organosiloxane of the present invention will be described in detail below.

The (meth) acryloyl group-containing organosiloxane of the present invention is obtained, for example, by subjecting a (meth)acryloyl group-containing alcohol (A) represented by the following formula (2): 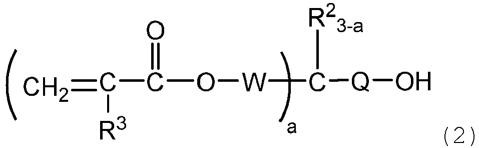
wherein a, R², R³, W, and Q are as defined above,
and a chlorosilyl group-containing organosiloxane (B) represented by the following formula (3): 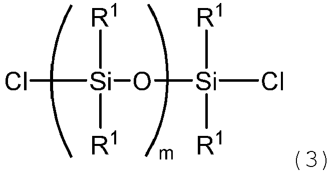
wherein R¹ is as defined above, m=n-1, and n is as defined above,
to dehydrochlorination in the presence of a basic catalyst (C) .

Examples of the (meth)acryloyl group-containing alcohol represented by the formula (2) include compounds represented by the following formulae.

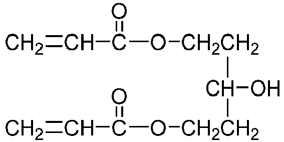

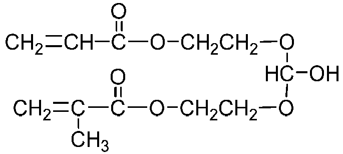

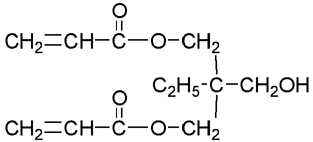

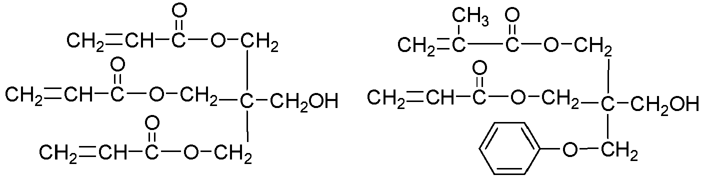

Examples of the chlorosilyl group-containing organosiloxane represented by the formula (3) include compounds represented by the following formulae.

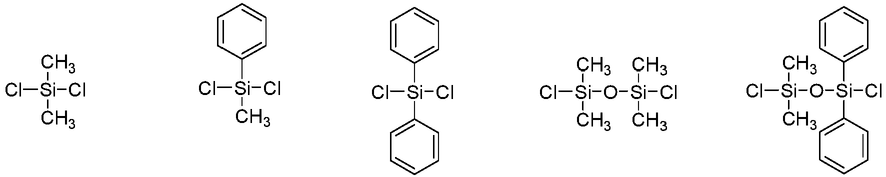

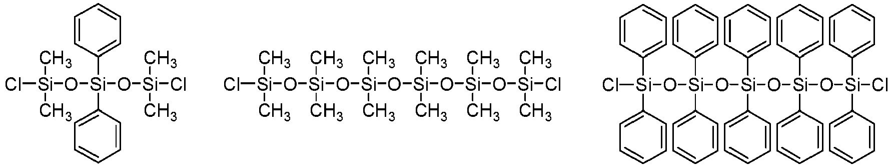

### [(C) Basic catalyst]

The basic catalyst accelerates the dehydrochlorination and is not particularly limited, as long as it forms a covalent bond with the hydrogen atom of the hydroxyl group of the (meth)acryloyl group-containing alcohol. Examples of the basic catalyst include amine catalysts, phosphorus catalysts, sulfur catalysts, hydroxide catalysts, and oxide catalysts. Amine catalysts and phosphine catalysts are preferred, and an amine catalyst is more preferred. Reaction conditions of the dehydrochlorination are not particularly limited and may be conducted according to a conventional manner.

Examples of the phosphine catalysts include aliphatic secondary phosphines such as dibutylphosphine and dicyclohexylphosphine, aliphatic tertiary phosphines such as trimethylphosphine, tributylphosphine, and trihexylphosphine, aliphatic diphosphines such as 1,2-(dimethyphosphino)ethane and 1,2-(dibutylphosphino)ethane, aromatic secondary phosphines such as diphenylphosphine, and aromatic tertiary phosphines such as triphenylphosphine and dimethylphenylphosphine. Among these, aliphatic tertiary phosphines and aromatic tertiary phosphines are preferred, and tributylphosphine and triphenylphosphine are particularly preferred.

Examples of the amine catalysts include aliphatic primary amines such as butylamine, hexylamine, and octylamine, aliphatic secondary amines such as diethylamine and dibutylamine, aliphatic tertiary amines such as triethylamine, triethanolamine, and N,N-diisopropylethylamine, aliphatic primary diamines such as ethylenediamine, tetramethylethylenediamine, and hexamethylenediamine, aromatic primary amines such as aniline and toluidine, and heterocyclic amines such as pyridine, piperidine, picoline, pyrrole, imidazole, oxazole, thiazole, diazabicycloundecene, and diazabicyclononene. Among these, aliphatic tertiary amines and heterocyclic amines are preferred, and triethylamine and pyridine are particularly preferred.

The dehydrochlorination may be conducted according to a conventional manner. For example, an amount of the (meth)acryloyl group-containing alcohol represented by the formula (2) may be 1 mol to 3 mol, per mol of the chlorosilyl group-containing organosiloxane represented by the formula (3). An amount of the catalyst may be a catalytically effective amount (catalytic amount) for making the dehydrochlorination proceed. For example, the amount is 1 mol to 3 mol, per mol of the (meth)acryloyl group-containing alcohol. Concerning reaction conditions, the reaction may be conducted, for example, at a temperature in the range of from 30 to 60 degrees C for 2 to 5 hours.

### EXAMPLES

The present invention will be explained below in further detail with reference to a series of the Examples, and the present invention is in no way limited by these Examples.

In the Examples, ¹H-NMR measurement was undertaken by an equipment produced by BRUKER, using deuterochloroform as a solvent and chloroform as an internal standard.

### [Example 1]

Dichlorodiphenylsilane (506 g) and toluene (506 g) were placed in a 5-L brown flask. After stirring for 10 minutes, 2-hydroxy-3-acryloxypropyl methacrylate (854 g, "NK Ester 701A", ex Shin-Nakamura Chemical) was added, followed by stirring for 10 minutes. Triethylamine (547 g) was added dropwise to the mixture, followed by stirring at 60 degrees C for 3 hours. The reaction mixture was subjected to filtration and to distillation at a reduced pressure to obtain a colorless transparent liquid product (yield, 750 g). According to the chemical shifts and the integration ratios by ¹H-NMR analysis, the product obtained was found to be the compound (A-1) represented by the following formula. The ¹H-NMR spectrum is shown as FIG. 1.

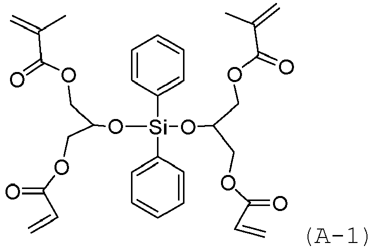

The chemical shifts and the integration ratios of ¹H-NMR are as follows.
δ2.0 (CH₂=C(CH₃)C(O)OCH₂CH(O)CH₂OC(O)CH=CH₂)6H
53.9 (CH₂=C(CH₃)C(O)OCH₂CH(O)CH₂OC(O)CH=CH₂)2H
54.1-4.5 (CH₂=C(CH₃)C(O)OCH₂CH(O)CH₂OC(O)CH=CH₂)8H
55.6 (CH₂=C(CH₃)C(O)OCH₂CH(O)CH₂OC(O)CH=CH₂)2H
55.8-6.5 (CH₂=C(CH₃)C(O)OCH₂CH(O)CH₂OC(O)CH=CH₂)8H
δ7.4-7 .8 (C₆H₅SiOC₆H₅)10H

### [Example 2] (compound (A-2) not according to the invention)

Dichlorodiphenylsilane (506 g) and toluene (506 g) were placed in a 5-L brown flask. After stirring for 10 minutes, 2-hydroxy-3-phenoxypropyl acrylate (977 g, "KAYARAD R-128H", ex Nippon Kayaku) was added, followed by stirring for 10 minutes. Triethylamine (607 g) was added dropwise to the mixture, followed by stirring at 60 degrees C for 3 hours. The reaction mixture was subjected to filtration and to distillation at a reduced pressure to obtain a colorless transparent liquid product (yield, 813 g). According to the chemical shifts and the integration ratios by ¹H-NMR analysis, the product obtained was found to be the compound (A-2) represented by the following formula.

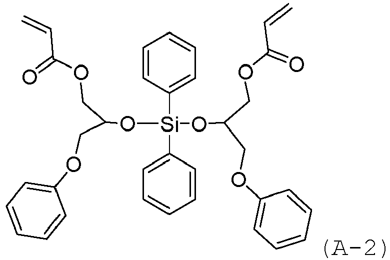

The chemical shifts and the integration ratios of ¹H-NMR are as follows.
δ3. 8-4 . 6 (C₆H₅OCH₂CH(O)CH₂OC(O)CH=CH₂)10H
δ5. 8-6 . 5 (-OC(O)CH=CH₂)6H
δ6.7-7 . 8 (C₆H₅OCH₂, C₆H₅SiOC₆H₅)20H

### [Example 3]

Dichlorodimethylsilane (258 g) and toluene (258 g) were placed in a 5-L brown flask. After stirring for 10 minutes, 2-hydroxy-3-acryloxypropyl methacrylate (854 g) was added, followed by stirring for 10 minutes. Triethylamine (547 g) was added dropwise to the mixture, followed by stirring at 60 degrees C for 3 hours. The reaction mixture was subjected to filtration and to distillation at a reduced pressure to obtain a colorless transparent liquid product (yield, 630 g). According to the chemical shifts and the integration ratios by ¹H-NMR analysis, the product obtained was found to be the compound (A-3) represented by the following formula.

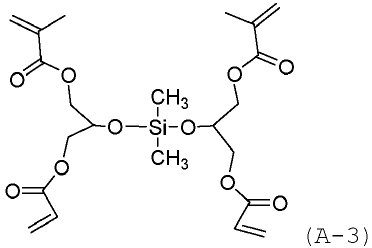

The chemical shifts and the integration ratios of ¹H-NMR are as follows.
δ0.0-0.5 (CH₃SiOCH₃)6H
δ1.9 (CH₂=C(CH₃)C(O)OCH₂CH(O)CH₂OC(O)CH=CH₂)6H
δ3.7-3 . 9 (CH₂=C(CH₃)C(O)OCH₂CH(O)CH₂OC(O)CH=CH₂)2H
54.1-4.5 (CH₂=C(CH₃)C(O)OCH₂CH(O)CH₂OC(O)CH=CH₂)8H
55.6 (CH₂=C(CH₃)C(O)OCH₂CH(O)CH₂OC(O)CH=CH₂)2H
δ5. 8-6 . 5 (CH₂=C(CH₃)C(O)OCH₂CH(O)CH₂OC(O)CH=CH₂)8H

### [Example 4]

1, 1, 3, 3-Tetramethyl-1,3-dichlorodisiloxane (406 g) and toluene (406 g) were placed in a 5-L brown flask. After stirring for 10 minutes, 2-hydroxy-2-methyl-3-acryloxypropyl acrylate (854 g) was added, followed by stirring for 10 minutes. Triethylamine (548 g) was added dropwise to the mixture, followed by stirring at 60 degrees C for 3 hours. The reaction mixture was subjected to filtration and to distillation at a reduced pressure to obtain a colorless transparent liquid product (yield, 720 g). According to the chemical shifts and the integration ratios by ¹H-NMR analysis, the product obtained was found to be the compound (A-4) represented by the following formula.

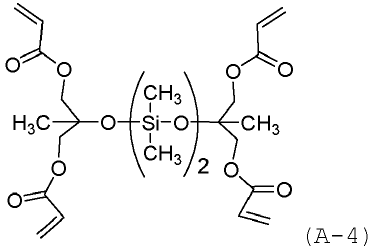

The chemical shifts and the integration ratios of ¹H-NMR are as follows.
δ0.0-0.5 (CH₃SiOCH₃)12H
δ1.8-2.3 (CH₂=CHC(O)OCH₂C(CH₃)(O)CH₂OC(O)CH=CH₂)6H
δ4.0-4.6 (CH₂=CHC(O)OCH₂C(CH₃)(O)CH₂OC(O)CH=CH₂)8H
δ 5. 6 (CH₂=CHC(O)OCH₂C(CH₃)(O)CH₂OC(O)CH=CH₂)4H
δ5.8-6.6 (CH₂=CHC(O)OCH₂C(CH₃)(O)CH₂OC(O)CH=CH₂)8H

### [Example 5]

1, 1, 3, 3, 5, 5, 7, 7-Octamethyl-1, 7-dichlorotetrasiloxane (703 g) and toluene (703 g) were placed in a 5-L brown flask. After stirring for 10 minutes, pentaerythritol triacrylate (1,311 g, "NK Ester A-TMM-3LM-N", ex Shin-Nakamura Chemical) was added, followed by stirring for 10 minutes. Triethylamine (607 g) was added dropwise to the mixture, followed by stirring at 60 degrees C for 3 hours. The reaction mixture was subjected to filtration and to distillation at a reduced pressure to obtain a colorless transparent liquid product (yield, 1,550 g). According to the chemical shifts and the integration ratios by ¹H-NMR analysis, the product obtained was found to be the compound (A-5) represented by the following formula.

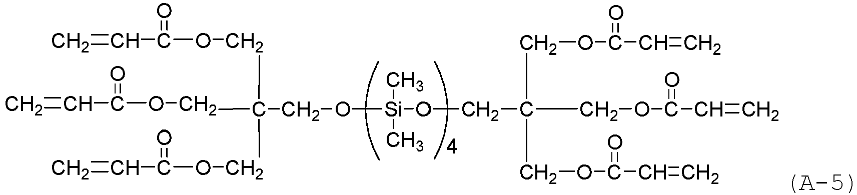

The chemical shifts and the integration ratios of ¹H-NMR are as follows.
50.0-0.5 (CH₃SiOCH₃)24H
δ3.7-4 . 0 (C-CH₂OC(O)CH=CH₂)12H
54.3-4.5 (SiO-CH₂C(CH₂OC(O)CH=CH₂)₃)4H
δ5.8-6.5 (C-CH₂OC(O)CH=CH₂)18H

The organosiloxane of the present invention has at least four up to six (meth)acryloyl groups, so that it provides a very strong cured product. A moiety having a (meth)acryloyl-containing group and an organosiloxane moiety are connected with each other via a -C-O-Si-structure in the present organosiloxane. Accordingly, the cured product is resinous and excellent in adhesion to a substrate. The present organosiloxane is useful, for instance, the present organosiloxane can be mixed with a polymerization initiator to give a heat-curable resin composition or a light-curable resin composition which cures by exposure to UV rays or electron rays.

## Claims

1. A (meth)acryloyl group-containing organosiloxane represented by the following formula (1): 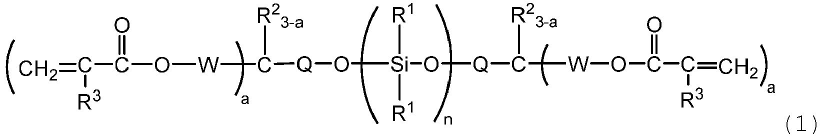
wherein R¹ is, independently of each other, an aliphatic hydrocarbon group having 1 to 10 carbon atoms or an aromatic hydrocarbon group having 6 to 12 carbon atoms,
R² is, independently of each other, a hydrogen atom, an alkoxy group having 1 to 6 carbon atoms, an aryloxy or aralkyloxy group having 6 to 12 carbon atoms, an aliphatic hydrocarbon group having 1 to 6 carbon atoms, or an aromatic hydrocarbon group having 6 to 12 carbon atoms,
R³ is, independently of each other, a hydrogen atom or a methyl group,
Q is a single bond or an alkylene group having 1 to 6 carbon atoms,
W is a divalent hydrocarbon group which has 1 to 6 carbon atoms and may have an ether bond,
a is 2 or 3, and
n is an integer of from 1 to 6.

2. The (meth)acryloyl group-containing organosiloxane according to claim 1, wherein R² is a hydrogen atom, an alkoxy group having 1 to 3 carbon atoms, an aryloxy group having 6 to 10 carbon atoms, an alkyl group having 1 to 3 carbon atoms, or an aryl group having 6 to 10 carbon atoms.

3. The (meth)acryloyl group-containing organosiloxane according to claim 1 or claim 2, wherein Q is a single bond or an alkylene group having 1 to 3 carbon atoms.

4. A method for preparing a (meth)acryloyl group-containing organosiloxane represented by the following formula (1): 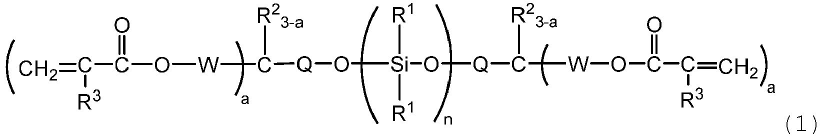
wherein R¹ is, independently of each other, an aliphatic hydrocarbon group having 1 to 10 carbon atoms or an aromatic hydrocarbon group having 6 to 12 carbon atoms,
R² is, independently of each other, a hydrogen atom, an alkoxy group having 1 to 6 carbon atoms, an aryloxy or aralkyloxy group having 6 to 12 carbon atoms, an aliphatic hydrocarbon group having 1 to 6 carbon atoms, or an aromatic hydrocarbon group having 6 to 12 carbon atoms,
R³ is, independently of each other, a hydrogen atom or a methyl group,
Q is a single bond or an alkylene group having 1 to 6 carbon atoms,
W is a divalent hydrocarbon group which has 1 to 6 carbon atoms and may have an ether bond,
a is 2 or 3, and
n is an integer of from 1 to 6,
wherein the method comprises the step of reacting a (meth)acryloyl group-containing alcohol represented by the following formula (2): 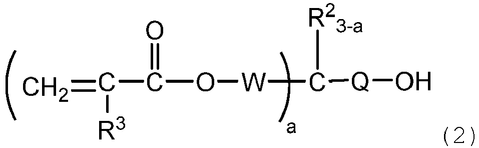
wherein a, R², R³, W and Q are as defined above,
with a chlorosilyl group-containing organosiloxane represented by the following formula (3): 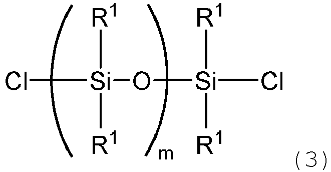
wherein R¹ is as defined above, m=n-1, and n is as defined above,
in the presence of (C) a basic catalyst.

5. The method according to claim 4, wherein component (C) is an amine catalyst.

## Patentansprüche

1. (Meth)acryloylgruppenhaltiges Organosiloxan, dargestellt durch die folgende Formel (1): 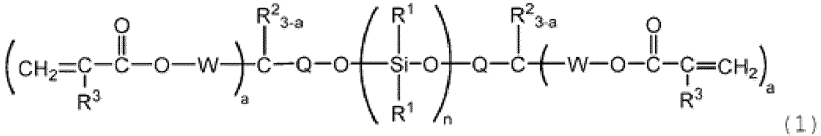
wobei R¹ unabhängig voneinander eine aliphatische Kohlenwasserstoffgruppe mit 1 bis 10 Kohlenstoffatomen oder eine aromatische Kohlenwasserstoffgruppe mit 6 bis 12 Kohlenstoffatomen ist,
R² unabhängig voneinander ein Wasserstoffatom, eine Alkoxygruppe mit 1 bis 6 Kohlenstoffatomen, eine Aryloxy- oder Aralkyloxygruppe mit 6 bis 12 Kohlenstoffatomen, eine aliphatische Kohlenwasserstoffgruppe mit 1 bis 6 Kohlenstoffatomen, oder eine aromatische Kohlenwasserstoffgruppe mit 6 bis 12 Kohlenstoffatomen ist,
R³ unabhängig voneinander ein Wasserstoffatom oder eine Methylgruppe ist,
Q eine Einfachbindung oder eine Alkylengruppe mit 1 bis 6 Kohlenstoffatomen ist,
W eine zweiwertige Kohlenwasserstoffgruppe ist, die 1 bis 6 Kohlenstoffatome hat und eine Etherbindung haben kann,
a 2 oder 3 ist, und
n eine ganze Zahl von von 1 bis 6 ist.

2. (Meth)acryloylgruppenhaltiges Organosiloxan nach Anspruch 1, wobei R² ein Wasserstoffatom, eine Alkoxygruppe mit 1 bis 3 Kohlenstoffatomen, eine Aryloxygruppe mit 6 bis 10 Kohlenstoffatomen, eine Alkylgruppe mit 1 bis 3 Kohlenstoffatomen, oder eine Arylgruppe mit 6 bis 10 Kohlenstoffatomen ist.

3. (Meth)acryloylgruppenhaltiges Organosiloxan nach Anspruch 1 oder Anspruch 2, wobei Q eine Einfachbindung oder eine Alkylengruppe mit 1 bis 3 Kohlenstoffatomen ist.

4. Verfahren zum Herstellen eines (meth)acryloylgruppenhaltigen Organosiloxans, dargestellt durch die folgende Formel (1): 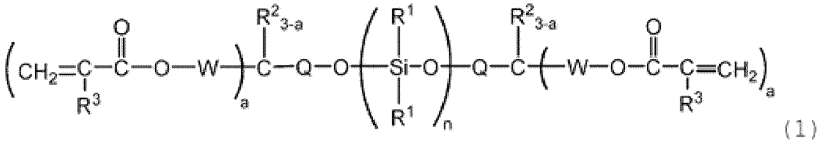
wobei R¹ unabhängig voneinander eine aliphatische Kohlenwasserstoffgruppe mit 1 bis 10 Kohlenstoffatomen oder eine aromatische Kohlenwasserstoffgruppe mit 6 bis 12 Kohlenstoffatomen ist,
R² unabhängig voneinander ein Wasserstoffatom, eine Alkoxygruppe mit 1 bis 6 Kohlenstoffatomen, eine Aryloxy- oder Aralkyloxygruppe mit 6 bis 12 Kohlenstoffatomen, eine aliphatische Kohlenwasserstoffgruppe mit 1 bis 6 Kohlenstoffatomen, oder eine aromatische Kohlenwasserstoffgruppe mit 6 bis 12 Kohlenstoffatomen ist,
R³ unabhängig voneinander ein Wasserstoffatom oder eine Methylgruppe ist,
Q eine Einfachbindung oder eine Alkylengruppe mit 1 bis 6 Kohlenstoffatomen ist,
W eine zweiwertige Kohlenwasserstoffgruppe ist, die 1 bis 6 Kohlenstoffatome hat und eine Etherbindung haben kann,
a 2 oder 3 ist, und
n eine ganze Zahl von 1 bis 6 ist,
wobei das Verfahren den Schritt von Umsetzen eines (meth)acryloylgruppenhaltigen Alkohols, dargestellt durch die folgende Formel (2): 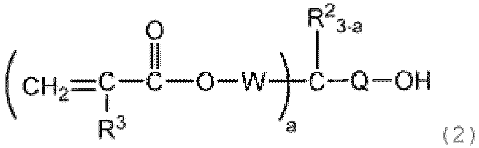
wobei a, R², R³, W und Q wie oben definiert sind,
mit einem chlorsilylgruppenhaltigen Organosiloxan, dargestellt durch die folgende Formel (3): 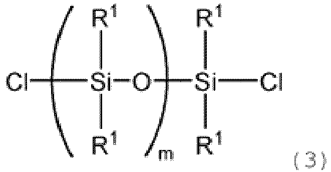
wobei R¹ wie oben definiert ist, m = n - 1, und n wie oben definiert ist,
in der Gegenwart von (C) eines basischen Katalysators umfasst.

5. Verfahren nach Anspruch 4, wobei Komponente (C) ein Aminkatalysator ist.

## Revendications

1. Organosiloxane contenant un groupe (méth)acryloyle représenté par la formule (1) suivante : 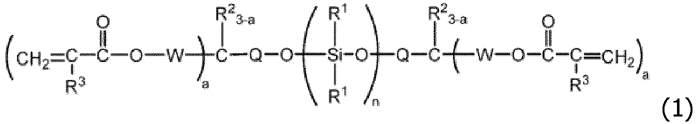
dans laquelle R₁ est, indépendamment les uns des autres, un groupe hydrocarboné aliphatique ayant 1 à 10 atomes de carbone ou un groupe hydrocarboné aromatique ayant 6 à 12 atomes de carbone,
R² est, indépendamment les uns des autres, un atome d'hydrogène, un groupe alcoxy ayant 1 à 6 atomes de carbone, un groupe aryloxy ou aralkyloxy ayant 6 à 12 atomes de carbone, un groupe hydrocarboné aliphatique ayant 1 à 6 atomes de carbone, ou un groupe hydrocarboné aromatique ayant 6 à 12 atomes de carbone,
R³ est, indépendamment les uns des autres, un atome d'hydrogène ou un groupe méthyle,
Q est une simple liaison ou un groupe alkylène ayant 1 à 6 atomes de carbone, W est un groupe hydrocarboné divalent qui a 1 à 6 atomes de carbone et peut avoir une liaison éther,
a est 2 ou 3, et
n est un entier de 1 à 6.

2. Organosiloxane contenant un groupe (méth)acryloyle selon la revendication 1, dans lequel R² est un atome d'hydrogène, un groupe alcoxy ayant 1 à 3 atomes de carbone, un groupe aryloxy ayant 6 à 10 atomes de carbone, un groupe alkyle ayant 1 à 3 atomes de carbone ou un groupe aryle ayant 6 à 10 atomes de carbone.

3. Organosiloxane contenant un groupe (méth)acryloyle selon la revendication 1 ou la revendication 2, dans lequel Q est une simple liaison ou un groupe alkylène ayant 1 à 3 atomes de carbone.

4. Procédé de préparation d'un organosiloxane contenant un groupe (méth)acryloyle représenté par la formule (1) suivante : 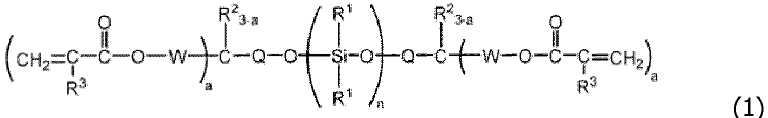
dans laquelle R₁ est, indépendamment les uns des autres, un groupe hydrocarboné aliphatique ayant 1 à 10 atomes de carbone ou un groupe hydrocarboné aromatique ayant 6 à 12 atomes de carbone,
R² est, indépendamment les uns des autres, un atome d'hydrogène, un groupe alcoxy ayant 1 à 6 atomes de carbone, un groupe aryloxy ou aralkyloxy ayant 6 à 12 atomes de carbone, un groupe hydrocarboné aliphatique ayant 1 à 6 atomes de carbone, ou un groupe hydrocarboné aromatique ayant 6 à 12 atomes de carbone,
R³ est, indépendamment les uns des autres, un atome d'hydrogène ou un groupe méthyle,
Q est une simple liaison ou un groupe alkylène ayant 1 à 6 atomes de carbone, W est un groupe hydrocarboné divalent qui a 1 à 6 atomes de carbone et peut avoir une liaison éther,
a est 2 ou 3, et
n est un entier de 1 à 6,
le procédé comprenant l'étape de réaction d'un alcool contenant un groupe (méth)acryloyle représenté par la formule (2) suivante : 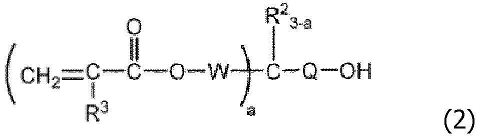
dans laquelle a, R², R³, W et Q sont tels que définis ci-dessus,
avec un organosiloxane contenant un groupe chlorosilyle représenté par la formule (3) suivante : 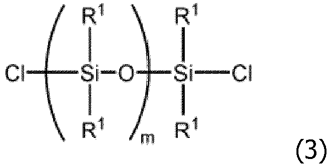
dans laquelle R¹ est tel que défini ci-dessus, m=n-1, et n est tel que défini ci-dessus,
en présence de (C) un catalyseur basique.

5. Procédé selon la revendication 4, dans lequel le composant (C) est un catalyseur aminé.
